# EUROPÄISCHE PATENTANMELDUNG

(11) **EP 1 937 046 A2**
(43) Veröffentlichungstag der Anmeldung: **25.06.2008**
(21) Anmeldenummer: 07023906.6
(22) Anmeldetag: 11.12.2007
(51) Int. Cl.: H05K 7/14

(54) **Verbesserte Befestigung einer Leiterplatte in einem Gehäuse eines elektronischen Gerätes**

(30) Priorität: 20.12.2006 DE 102006060193
(71) Anmelder: Hirschmann Car Communication GmbH, 72654 Neckartenzlingen (DE)
(72) Erfinder: Silva, David, 72622 Nürtigen (DE)
(74) Vertreter: Thul, Hermann

(57) **Zusammenfassung**

Die Erfindung betrifft eine Vorrichtung zur Anordnung einer Leiterplatte (3) eines elektronischen Geräts in einem Gehäuse (1, 2) des elektronischen Geräts, wobei die Leiterplatte (3) Bohrungen aufweist, in welche Befestigungsschrauben (4) eingesetzt sind, mit denen die Leiterplatte (3) an dem Gehäuse (1, 2) lagefixiert und befestigt ist, wobei erfindungsgemäß vorgesehen ist, dass in einer Bohrung innerhalb des Randbereichs in der Leiterplatte (3) eine Befestigungsmutter (6) eingesetzt ist, mit der die Leiterplatte (3) durch Einschrauben einer Befestigungsschraube (4) an dem Gehäuse (1, 2) festgelegt ist.

## Beschreibung

Es sind grundsätzlich elektronische Geräte bekannt, die ein vorzugsweise mehrteiliges Gehäuse mit einer darin eingesetzten Leiterplatte mit elektronischen Bauteilen zur Realisierung der Funktion des elektronischen Gerätes aufweisen. Bei den elektronischen Geräten handelt es sich beispielsweise um TV-Tuner für den Einsatz in Fahrzeugen. Bisher waren diese Gehäuse so gestaltet, dass sie möglichst kompakt aufgebaut sind, um Bauraum, der im Fahrzeug knapp ist, zu sparen. Daher war es vorgesehen, dass in dem Gehäuse mehrere kleinere Leiterplatten eingesetzt werden, die untereinander in entsprechender Weise verbunden sind, um die Funktion des elektronischen Gerätes realisieren zu können. Dies führte zwar dazu, dass die Erstreckungen des Gehäuses in Richtung Länge und Breite relativ kompakt gehalten werden können, allerdings wuchs durch die dann erforderliche senkrechte Anordnung der mehreren Leiterplatten in dem Gehäuse dessen Höhe. Aufgrund der relativ kleinen Erstreckung der Leiterplatten gab es bisher auch keine Probleme, dass Vibrationen, Temperaturschwankungen oder dergleichen, wie sie im Fahrzeug alltäglich sind, zu einer Verformung der Leiterplatten und/oder des Gehäuses, woraus Fehlfunktionen resultieren können, führen.

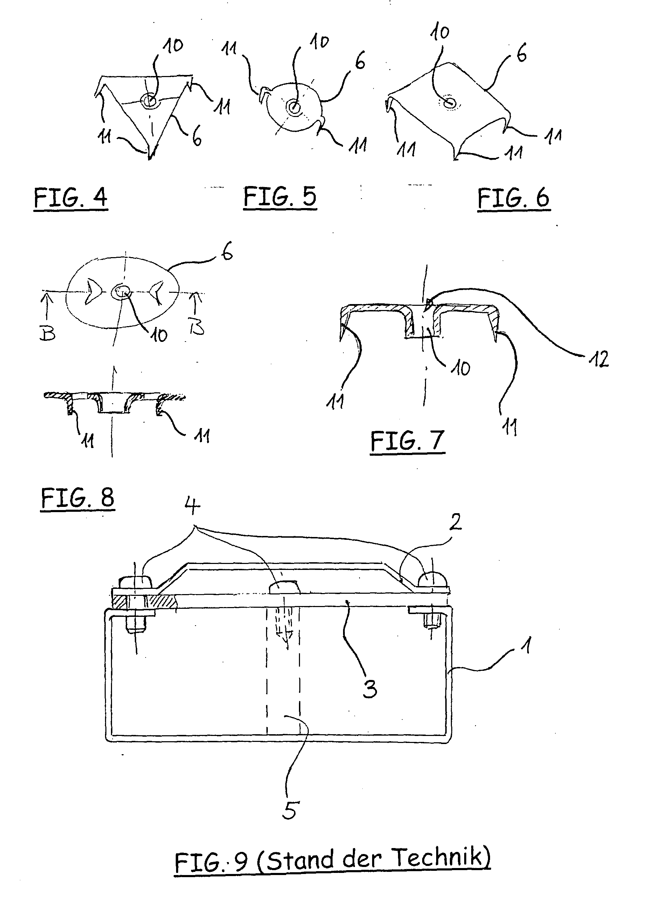

Der vorstehend beschriebene Stand der Technik ist in Figur 9 beispielhaft gezeigt. Ein Gehäuse, insbesondere ein Unterteil (1), eines elektronischen Geräts, wird mit einem Gehäusedeckel (2) verschlossen. Dabei ist vorgesehen, dass eine Leiterplatte (3) im Randbereich Bohrungen aufweist, wobei durch diese Bohrungen und korrespondierenden Bohrungen in dem Gehäusedeckel (2) Befestigungsschrauben (4) durchgeführt und anschließend mit dem Gehäuseunterteil (1) verschraubt werden. Auf Grund der flächigen Erstreckung der Leiterplatte (3) ist es erforderlich, dass diese in etwa mittig zumindest eine weitere Bohrung aufweist, durch welche eine weitere Befestigungsschraube (4) einsetzbar ist. Um Durchbiegungen der großflächig gestalteten Leiterplatte (3) zu vermeiden, ist im Stand der Technik ein Distanzstück (5) vorgesehen, welches in seinem einem Endbereich mit der Befestigungsschraube (4) verschraubt und in seinem anderen Endbereich an dem Gehäuseunterteil (1) befestigt ist. Durch dieses Distanzstück (5) werden zwar Durchbiegungen der Leiterplatte (3) vermieden, jedoch ist der Aufwand der Montage relativ groß, da hier verschiedene Einzelteile gehandhabt werden müssen. Außerdem sind mehrere Befestigungsschritte hintereinander erforderlich, da zunächst die Leiterplatte (3) über das Distanzstück (5) an dem Gehäuseunterteil (1) mittels der Befestigungsschraube (4) festgelegt werden muss, wobei erst danach der Gehäusedeckel (2) mit den weiteren Befestigungsschrauben (4) unter Zwischenlegung der Leiterplatte (3) an dem Gehäuseunterteil (1) befestigt werden kann. Dadurch ist auch der Montageaufwand recht hoch.

Der Erfindung liegt daher die Aufgabe zu Grunde, den Montageaufwand einer Leiterplatte in einem Gehäuse eines elektronischen Geräts zu verringern, wobei gleichzeitig durch die Befestigung der Leiterplatte an dem Gehäuse Durchbiegungen der Leiterplatte vermieden werden sollen.

Diese Aufgabe ist durch die Merkmale des Patentanspruchs 1 gelöst.

Erfindungsgemäß ist vorgesehen, dass in einer Bohrung innerhalb des Randbereichs in der Leiterplatte eine Befestigungsmutter eingesetzt ist, mit der die Leiterplatte durch Einschrauben der Befestigungsschraube an dem Gehäuse, insbesondere dem Gehäusedeckel, festgelegt ist. Durch die schon befestigte Befestigungsmutter in der Leiterplatte kann das aus dem Stand der Technik bekannte Distanzstück entfallen, da sich die Leiterplatte an dem Gehäuse, insbesondere dem Gehäusedeckel, abstützt, wenn die Befestigungsschraube in die Befestigungsmutter eingeschraubt wurde. Dadurch entfallen in vorteilhafter Weise Bauteile, wobei gleichzeitig der Montageaufwand dadurch verringert wird, dass alle Befestigungsschrauben von außen zugänglich und damit handhabbar sind. gleiches gilt im Übrigen für den Demontagefall, wenn z. B. die Leiterplatte mit ihren elektrischen und elektronischen Bauteilen zur Realisierung der Funktion des elektronischen Geräts einen Defekt aufweisen sollte und ausgetauscht werden muss. Außerdem ist es von Vorteil, dass sich die Leiterplatte mit der eingesetzten Befestigungsmutter an dem Gehäusedeckel abstützt, da dadurch das gesamte Gehäuse des elektronischen Geräts flacher bauen kann.

Die vorliegende Erfindung sieht also in vorteilhafter Weise vor, dass in einem relativ flach bauenden Gehäuse nur noch eine Leiterplatte angeordnet wird, die gegenüber den Leiterplatten aus dem Stand der Technik eine relativ größere Erstreckung in Richtung Länge und Breite aufweist. Vorzugsweise erstreckt sich die Leiterplatte bis in die Randbereiche des Gehäuses und schließt ebenso vorzugsweise dort mit der Seitenkante des Gehäuses ab. Diese Flachbauweise des Gehäuses, insbesondere für einen TV-Tuner eines Fahrzeuges, hat den Vorteil, dass ein solches Gehäuse besser im Fahrzeug integrierbar ist (z. B. zwischen einem Dach und einem Dachhimmel des Fahrzeuges).

Die weiteren Ausgestaltungen der Erfindung, auf die diese jedoch nicht beschränkt ist, und die sich daraus ergebenden Vorteile werden im Folgenden unter Zuhilfenahme der Figuren erläutert.

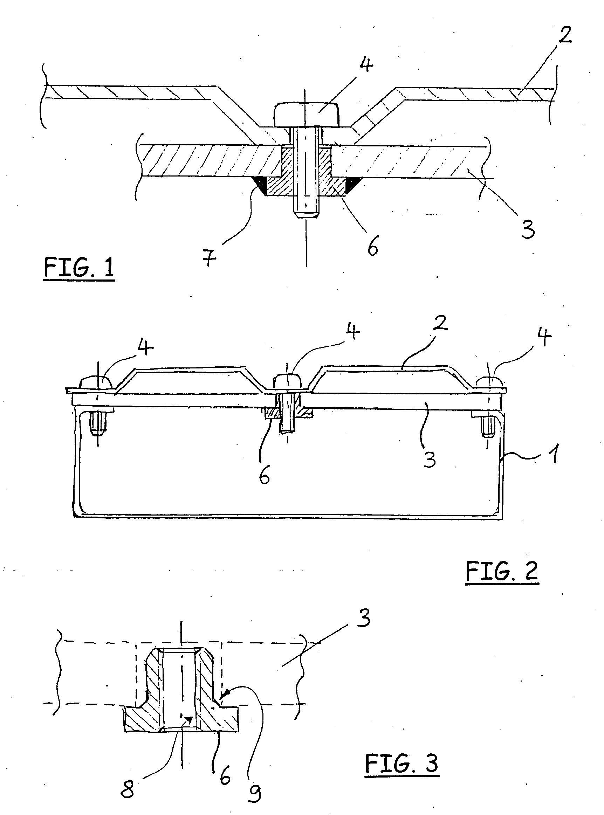

Die Figuren 1 bis 8 zeigen, soweit im Einzelnen dargestellt, ein Gehäuse eines elektronischen Geräts, wobei in dem Gehäuse eine Leiterplatte 3, vorzugsweise nur eine einzige, großflächige Leiterplatte 3 mit nicht dargestellten elektrischen und elektronischen Bauteilen zur Realisierung der Funktion des elektronischen Geräts dargestellt sind.

Figur 1 zeigt die prinzipielle Ausgestaltung der Erfindung, wobei ein Gehäusedeckel 2 zumindest eine von seinem Randbereich beabstandete Vertiefung mit einer Bohrung für die Befestigungsschraube 4 aufweist. In der Leiterplatte 3 ist eine Befestigungsmutter 6 eingesetzt, wobei in diesem Fall die Befestigungsmutter 6 über eine Lötzinnverbindung 7 mit einer hier nicht dargestellten Kupferoberfläche der Leiterplatte 3 verlötet ist. Diese Befestigung der Befestigungsmutter 4 an der Leiterplatte 3 erfolgt in besonders vorteilhafter Weise dadurch, dass die Befestigungsmutter 6 als SMD-Bauteil ausgebildet ist und durch einen Automaten bestückt wird, wobei nach dem Bestückvorgang ein Lötverfahren, insbesondere ein Reflow-Lötverfahren durchgeführt wird, sodass die Befestigungsmutter 6 auf der die Bohrung in der Leiterplatte 3 umgebende Kupferfläche festgelegt wird. Anschließend wird die Leiterplatte 3 mit einem Gehäuseunterteil in Verbindung gebracht, anschließend der Gehäusedeckel 2 aufgesetzt und die Befestigungsschrauben 4 sowohl im Randbereich als auch an der vorgesehenen Stelle innerhalb des Randbereichs eingesetzt und festgeschraubt. Dadurch stützt sich die Leiterplatte 3 im Randbereich und auch zumindest einmal, ggf. auch mehrmals, innerhalb der Umrandung des Gehäusedeckels 2 an diesem ab. Dadurch werden auf Grund der Steifigkeit, die der Gehäusedeckel 2 zum Zweck der Vermeidung von Beschädigungen von Außen aufweist, wirksam vermieden. In diesem Zusammenhang wird auf Figur 2 verwiesen, bei der im Schnitt die gesamte Anordnung aus Gehäuseunterteil 1, Gehäusedeckel 2 und befestigter Leiterplatte 3 zu erkennen ist. Hier ist insbesondere erkennbar, dass der Gehäusedeckel 2 zumindest eine von seinem Randbereich beabstandete Vertiefung mit einer Bohrung für die Befestigungsschraube 4 aufweist und die Lage der Bohrung in dem Gehäusedeckel 2 mit der Lage der Befestigungsmutter 4 in der Leiterplatte 3 korrespondiert. Die Vertiefung in dem Gehäusedeckel 2 hat darüber hinaus den Vorteil, dass dadurch Durchbiegungen des Gehäusedeckels 2 vermieden werden, was in vorteilhafter Weise zur Folge hat, dass auch Durchbiegungen der Leiterplatte 3 vermieden werden, sodass die an dem Gehäuseunterteil 1 und dem Gehäusedeckel 2 befestigte Leiterplatte 3 ein insgesamt sehr steifes Gebilde realisieren, wobei Durchbiegungen weitestgehend vermieden werden.

Verschiedene Ausgestaltungen für die Befestigungsmutter 6 sind einerseits der Figur 3 und andererseits den Figuren 4 bis 8 zu entnehmen.

In Figur 3 ist gezeigt, dass die Befestigungsmutter 6 als ein Drehteil ausgebildet ist und ein Innengewinde 8 aufweist. Durch das Einsetzen einer korrespondierenden Befestigungsschraube, ebenfalls mit Feingewinde, kann die Leiterplatte 3 in diesem Fall mit sehr hoher Genauigkeit in Bezug auf das Gehäuse des elektronischen Geräts positioniert werden. In einer besonderen Ausgestaltung der Erfindung ist vorgesehen, dass die Befestigungsmutter 6 einen in die Bohrung in der Leiterplatte 3 einsetzbaren durchmesserkleineren Teil und einen an der Leiterplatte 3 festlegbaren durchmessergrößeren Teil aufweist, wobei in dem Bereich, in dem der durchmessergrößere Teil in den durchmesserkleineren Teil übergeht, eine Zentrierfase 9 vorgesehen ist. Durch diese Zentrierfase 9 wird die Befestigungsmutter 6 in der Bohrung in der Leiterplatte 3 mittig beim Einsetzen ausgerichtet und kann anschließend mit der Leiterplatte 3, insbesondere wieder durch ein Lötverfahren, verbunden werden.

In den weiteren Figuren 4 bis 8 sind verschiedene Ausführungen der Befestigungsmutter 6 gezeigt, wobei in diesen Fällen die Befestigungsmutter 6 als ein Blechteil ausgebildet ist. Ein solches Blechteil kann aus einem Stück Blech sehr schnell, kostengünstig und in hohen Stückzahlen z. B. in einem Standsbiegeverfahren hergestellt werden.

Die Figuren 4 bis 6 sowie 8 zeigen in der Ansicht dreieckförmige, runde, quadratische (oder rechteckige) sowie ovale Ausgestaltungen der Befestigungsmutter 6, wobei auch andere Formgebungen, beispielsweise polygonale Formgebungen, denkbar sind. Diesen verschiedenen Ausgestaltungen ist gemeinsam, dass sie im Wesentlichen flächig ausgebildet sind, um sich auch flächig auf der Oberfläche der Leiterplatte 3 abstützen zu können. Außerdem weisen sie eine Öffnung 10 auf, in die die Befestigungsschraube 4 eingeschraubt werden kann.

Weiterhin weist die als Blechteil ausgebildete Befestigungsmutter 6 zumindest zwei Zentrierspitzen 11 auf, die in weitere Bohrungen in der Leiterplatte 3 eingreifen, um die Befestigungsmutter 6 dort festzulegen. Diese Zentrierspitzen 11 können entweder nur eine Ausrichtfunktion der Befestigungsmutter 6 in Bezug auf die Leiterplatte 3 haben, ohne dass sie auch eine Befestigungsfunktion übernehmen. Die Befestigung der Mutter 6 an der Leiterplatte 3 erfolgt dann durch andere Maßnahmen, wie z. B. Einpressen oder Einklipsen. Ergänzend oder alternativ dazu ist es denkbar, dass die Zentrierspitzen 11 neben eine Ausrichtfunktion auch eine Befestigungsfunktion übernehmen. In diesem Fall sind die Zentrierspitzen 11 so lang ausgebildet, dass sie länger sind als die Dicke der Leiterplatte 3, sodass sie nach dem Einsetzen der Befestigungsmutter 6 in die zugehörige Bohrung in der Leiterplatte 3 durch die Leiterplatte 3 hindurchragen und auf der anderen Seite abstehen. Dadurch können sie z. B. umgebogen werden und somit die Befestigungsmutter 6 an der Leiterplatte 3 befestigen. Hier ist es in einer weiteren Ausgestaltung der Erfindung wesentlich, dass die Öffnung 10 als Düsenform 12 (siehe z. B. Figur 7 und 8) ausgebildet ist, da somit gewindefurchende oder selbstschneidende Befestigungsschrauben oder auch Blechschrauben für die Befestigung des Gehäusedeckels 2 unter Zwischenlage der Leiterplatte 3 an dem Gehäuseunterteil 1 zur Anwendung kommen können.

In Figur 8 ist die Alternative dargestellt, dass die Zentrierspitzen 11 nicht am Rand der Befestigungsmutter 6 angeordnet sind, sondern ergänzend oder alternativ auch nach innen vom Rand beabstandet angeordnet sein können. In diesem Fall sind sie aus der Fläche der Befestigungsmutter 6 ausgestanzt und umgebogen.

Eine wichtige und wesentliche Alternative der Erfindung ist darin zu sehen, dass anstelle der Befestigungsschrauben zur Festlegung der Leiterplatte und des Gehäusedeckels an dem Gehäuseunterteil in umgekehrter Weise Befestigungsmuttern vorgesehen sind, während die bisher beschriebenen Befestigungsmuttern bzw. Gewindebereiche des Gehäuseunterteils als Schrauben ausgebildet sind.

### Bezugszeichenliste:

- 1.: Unterteil
- 2.: Gehäusedeckel
- 3.: Leiterplatte
- 4.: Befestigungsschraube
- 5.: Distanzstück
- 6.: Befestigungsmutter
- 7.: Lötzinn
- 8.: Innengewinde
- 9.: Zentrierfase
- 10.: Öffnung
- 11.: Zentrierspitze
- 12.: Düsenform

## Patentansprüche

1. Vorrichtung zur Anordnung einer Leiterplatte (3) eines elektronischen Geräts in einem Gehäuse (1, 2) des elektronischen Geräts, wobei die Leiterplatte (3) Bohrungen aufweist, in welche Befestigungsschrauben (4) eingesetzt sind, mit denen die Leiterplatte (3) an dem Gehäuse (1, 2) lagefixiert und befestigt ist, **dadurch gekennzeichnet, dass** in einer Bohrung innerhalb des Randbereichs in der Leiterplatte (3) eine Befestigungsmutter (6) eingesetzt ist, mit der die Leiterplatte (3) durch Einschrauben einer Befestigungsschraube (4) an dem Gehäuse (1, 2) festgelegt ist.

2. Vorrichtung nach Anspruch 1, **dadurch gekennzeichnet, dass** das Gehäuse (1, 2) einen Gehäusedeckel (2) aufweist, wobei der Gehäusedeckel (2) zumindest eine von seinem Randbereich beabstandete Vertiefung mit einer Bohrung für die Befestigungsschraube (4) aufweist und die Lage der Bohrung mit in der Vertiefung mit der Lage der Befestigungsmutter (6) in der Leiterplatte (3) korrespondiert.

3. Vorrichtung nach Anspruch 1 oder 2, **dadurch gekennzeichnet, dass** die Befestigungsmutter (6) mit der Leiterplatte (3) verlötet ist.

4. Vorrichtung nach Anspruch 1 oder 2, **dadurch gekennzeichnet, dass** die Befestigungsmutter (6) in die Bohrung in der Leiterplatte (3) eingepresst ist.

5. Vorrichtung nach einem der vorhergehenden Ansprüche, **dadurch gekennzeichnet, dass** die Befestigungsmutter (6) als ein Drehteil ausgebildet ist und ein Innengewinde (8) aufweist.

6. Vorrichtung nach Anspruch 5, **dadurch gekennzeichnet, dass** die Befestigungsmutter (6) einen in die Bohrung in der Leiterplatte (3) einsetzbaren durchmesserkleineren Teil und einen an der Leiterplatte (3) festlegbaren durchmessergrößeren Teil aufweist, wobei in dem Bereich, in dem der durchmessergrößere Teil in den durchmesserkleineren Teil übergeht, eine Zentrierfase (9) vorgesehen ist.

7. Vorrichtung nach einem der vorhergehenden Ansprüche, **dadurch gekennzeichnet, dass** die als ein Blechteil ausgebildete Befestigungsmutter (6) eine Öffnung (10) zur Aufnahme der Befestigungsschraube (4), die als selbstschneidende Schraube ausgebildet ist, sowie zumindest zwei Zentrierspitzen (11) aufweist.

8. Vorrichtung nach Anspruch 7, **dadurch gekennzeichnet, dass** die Öffnung (10) in der Befestigungsmutter (6) als Düsenform (12) ausgebildet ist.

9. Vorrichtung nach Anspruch 7 oder 8, **dadurch gekennzeichnet, dass** die von der Befestigungsmutter (6) ausgehenden Zentrierspitzen (11) eine größere Länge aufweisen als die Leiterplatte (3) dick ist, sodass sie über die Oberfläche der Leiterplatte (3) hinausragen und nach dem Einsetzen der Befestigungsmutter (6) in die Bohrung in der Leiterplatte (3) umgebogen werden.
